# EUROPÄISCHE PATENTSCHRIFT

(11) **EP 2 531 384 B1**
(45) Veröffentlichungstag und Bekanntmachung des Hinweises auf die Patenterteilung: **14.12.2016**
(21) Anmeldenummer: 11705173.0
(22) Anmeldetag: 01.02.2011
(51) Int. Cl.: B60R 25/00, G07C 9/00

(54) **VIRTUELLER SCHALTER UND VERFAHREN ZUM BETRIEB EINES SOLCHEN**
VIRTUAL SWITCH AND METHOD FOR OPERATING SAME
COMMUTATEUR VIRTUEL ET PROCÉDÉ POUR LE FAIRE FONCTIONNER

(30) Priorität: 22.04.2010 DE 102010018164; 01.02.2010 DE 102010009149
(43) Veröffentlichungstag der Anmeldung: 12.12.2012
(60) Teilanmeldung: 16165408.2
(73) Patentinhaber: Huf Hülsbeck & Fürst GmbH & Co. KG, 42551 Velbert (DE)
(72) Erfinder: VAN GASTEL, Peter, 42699 Solingen (DE)
(74) Vertreter: Vogel, Andreas
(86) Internationale Anmeldenummer: PCT/EP2011/051366
(87) Internationale Veröffentlichungsnummer: WO 2011/092341

(56) Entgegenhaltungen:
- EP-A1- 2 098 670
- EP-A2- 0 770 749
- DE-A1-102006 037 237
- DE-A1-102009 017 404

## Beschreibung

Die vorliegende Erfindung betrifft ein Verfahren zum Betätigen eines virtuellen Schalters gemäß des Oberbegriffes von Anspruch 1. Derartige virtuelle Schalter dienen dazu, ein bewegliches Teil, wie z. B. eine Heckklappe, eine Tür oder dergleichen bei einem Fahrzeug, insbesondere Kraftfahrzeug, zu betätigen. Hierdurch soll der Komfort des Fahrzeuges erhöht werden, da es möglich ist, das bewegliche Teil zu öffnen, ohne hierzu die Hände zu benötigen. Ebenfalls ist die vorliegende Erfindung auch auf eine Vorrichtung zur Betätigung des virtuellen Schalters gemäß des Oberbegriffs von Anspruch 10 gerichtet.

Die Druckschrift DE 10 2009 017 404 A1 offenbart z. B. einen virtuellen Schalter zum automatischen Öffnen bzw. Verschließen eines beweglichen Teils bei einem Fahrzeug. Aus der Druckschrift EP 2 098 670 A1 geht ebenfalls ein Fahrzeug mit einem virtuellen Schalter für ein bewegliches Teil hervor. Die Druckschrift EP 0 770 749 A2 offenbart ebenfalls einen virtuellen Schalter.

Grundsätzlich besteht bei diesen virtuellen Schaltern das Problem, dass diese auch bereits dann ein Schaltsignal und damit eine Betätigung auslösen, wenn ein nicht gewünschtes Objekt, wie z. B. eine Katze oder ein Ball von dem virtuellen Schalter messtechnisch erfasst wird.

Somit ist es Aufgabe der vorliegenden Erfindung ein Verfahren und eine Vorrichtung bereitzustellen, die eine erhöhte Betriebssicherheit des virtuellen Schalters ermöglicht. Dabei sollen insbesondere Fehlsignale des virtuellen Schalters vermieden werden.

Die vorliegende Erfindung wird durch die Merkmale des Anspruches 1, insbesondere aus dem kennzeichnenden Teil, gelöst. Darüber hinaus wird die Aufgabe auch durch die erfindungsgemäße Vorrichtung aus dem Anspruch 10 gelöst. In den abhängigen Unteransprüchen sind vorteilhafte Ausgestaltungen der Erfindung aufgeführt.

Im Sinne dieser Erfindung wird unter dem Begriff "bewegliches Teil", jede Tür, Seiten- oder Schiebetür, Klappe oder dergleichen eines Fahrzeuges verstanden, die wenigstens einen Schließzustand und einen Öffnungszustand aufweist, wobei der Schließzustand durch ein elektrisches und/oder mechanisches Schloss erreicht wird, um ein ungewolltes oder unberechtigtes Öffnen zu verhindern. Insbesondere kann das Schloss dieses beweglichen Teils mit einer Zentralverriegelung, vorzugsweise als "Aktiv-" bzw. "Passive Keyless-Go System", vom Fahrzeug zusammenwirken. Das Fahrzeug selbst kann ein Kraftfahrzeug sein.

Die vorliegende Erfindung sieht ein Verfahren zum Betätigen eines virtuellen Schalters mit einem Sensorsystem vor, welches eine Betätigung des Schalters erfasst, wobei das Sensorsystem zumindest zwei berührungslose Sensoren aufweist. Diese berührungslosen Sensoren können zweckmäßigerweise als Näherungssensoren, insbesondere Kapazitätssensoren, ausgestaltet sein. Dabei sieht die erste erfindungsgemäße Lösung des Verfahrens vor, dass die folgenden Schritte ablaufen:
a) Starten des Verfahrens
b) Überwachen von wenigstens einem ersten Sensor
c) Starten eines ersten Timers für eine erste Zeitspanne, falls der erste Sensor aktiviert wird, insbesondere durch ein angenähertes Objekt (z. B. eine Person)
d) Starten eines zweiten Timers für eine zweite Zeitspanne, falls der zweite Sensor aktiviert wird, insbesondere durch das angenäherte Objekt und die erste Zeitspanne noch nicht überschritten ist
e') Betätigen des virtuellen Schalters, falls zumindest zwei Sensoren deaktiviert sind und die zweite Zeitspanne noch nicht überschritten ist
und wobei insbesondere die Schritte a) bis e') teilweise gleichzeitig oder zeitlich nacheinander ablaufen.

Bei der Überwachung der Sensorik wird permanent geprüft, ob sich ein Objekt (z. B. eine Person, Fahrer des Fahrzeuges) dem entsprechenden Sensor genähert hat oder nicht. Sofern sich ein Objekt dem Sensor genähert hat, wird im Rahmen dieser Erfindung davon geredet, dass dieser aktiviert wurde. Ansonsten, wenn der Sensor eben kein Objekt in seinem Detektionsbereich feststellen kann, wird im Rahmen dieser Erfindung davon geredet, dass der Sensor deaktiviert ist. Eine Deaktivierung des Sensors liegt auch vor, falls der Messwert des jeweiligen Sensors unter einem definierten Schwellenwert liegt. In diesem Fall reicht z. B. die Annäherung des Objektes noch aus, um den Sensor zu aktivieren.

Eine zweite unabhängige Lösung des erfindungsgemäßen Verfahrens sieht vor, dass das erfindungsgemäße Verfahren erst wieder (gemeint ist: erneut) gestartet wird, wenn alle Sensoren deaktiviert sind. Hierbei kann zunächst der erste Sensor und dann der zweite Sensor deaktiviert sein. Ebenfalls kann auch zunächst der zweite Sensor und dann der erste Sensor deaktiviert werden. Auch können beide Sensoren gleichzeitig deaktiviert werden, um das erfindungsgemäße Verfahren erneut zu starten. Somit setzt diese Lösung voraus, dass die Sensoren des Sensorsystems beide deaktiviert sind, bevor der Schritt a), nämlich Starten des Verfahrens, eingeleitet werden kann. Dieses setzt jedoch voraus, dass sich kein Objekt im Detektionsbereich der Sensoren befindet. Optional kann ein weiterer Timer vorgesehen sein, der für eine vorgegebene Zeitspanne, z. B. zwischen von 0,5 bis 2 min, läuft. Nach Ablauf des Timers wird das erfindungsgemäße Verfahren auch dann mit Schritt a) gestartet, auch wenn noch ein Sensor aktiviert sein sollte.

Ebenfalls kann es vorgesehen sein, dass vor dem ersten Starten des erfindungsgemäßen Verfahrens zunächst ein Kalibrierverfahren abläuft, um das Sensorsystem mit den Sensoren zu kalibrieren. Dieses Kalibrierverfahren wird somit beim ersten Einschalten des virtuellen Schalters bzw. dessen Sensorsystems gestartet. Erst wenn das Kalibrierungsverfahren ordnungsgemäß durchgeführt worden ist, beginnt dann das erfindungsgemäße Verfahren mit dem Schritt a) bzw. wenn alle Sensoren deaktiviert sind. Das Kalibrierverfahren dient dazu, das Sensorsystem auf die aktuellen Messbedingungen einzustellen. Diese verändern sich z. B. durch die Witterungsverhältnisse und die Messumgebung (z. B. Hindernisse) sowie gegebenenfalls die Verschmutzung des Fahrzeuges. Zum Kalibrierverfahren selbst kann ein Kalibriersensor vorgesehen sein, anhand dessen die eigentlichen Messsensoren kalibriert werden. Ebenfalls können auch vorgegebene Schwellwerte zur Kalibrierung der einzelnen Sensoren herangezogen werden.

Bei dem erfindungsgemäßen Verfahren kann es vorgesehen sein, dass nach Schritt d) zunächst der erste Sensor deaktiviert wird, bevor Schritt e) beginnt, wobei hierbei der zweite Sensor deaktiviert wird. Ebenfalls ist es denkbar, dass die Reihenfolge der Deaktivierung der beiden Sensoren vertauscht wird, so dass zunächst nach Schritt d) der zweite Sensor deaktiviert wird und dann im Schritt e) der erste Sensor deaktiviert wird. Durch diese vorgegebene Reihenfolge lässt sich ein Bewegungsmuster des Objektes im Detektionsbereich der Sensoren klar und deutlich erfassen. Optional besteht die Möglichkeit den virtuellen Schalter im Rahmen eines "Lernablaufes" auf ein gewünschtes Bewegungsmuster zu trainieren. Hierbei muss dem virtuellen Schalter nur mitgeteilt werden, dass das folgende, gemessene Bewegungsmuster als Vergleichverfahren für spätere Betätigungen dient.

Bei dem Schritt e') wird somit vorausgesetzt, dass das erfasste Objekt aus den Detektionsbereichen von zumindest zwei Sensoren wieder entfernt worden ist, wodurch der virtuelle Schalter betätigt wird, falls die zweite Zeitspanne noch nicht überschritten ist. Da jedoch auch die Reihenfolge der Aktivierung der entsprechenden Sensoren vorgebbar ist, lässt sich so ein genaues Bewegungsmuster definieren, bei dem nur der virtuelle Schalter betätigt wird. Durch den Einsatz von einem weiteren Sensor kann ggf. auch die Messgenauigkeit des virtuellen Schalters erhöht werden.

Bei dem erfindungsgemäßen Verfahren kann es vorgesehen sein, dass die erste Zeitspanne und/oder die zweite Zeitspanne für die beiden Timer vorgegeben ist. Wie bereits erwähnt, werden die Timer durch ihre jeweiligen Sensoren gestartet, sobald diese durch ein angenähertes Objekt aktiviert worden sind. Um möglichst ein zufälliges Auslösen des virtuellen Schalters zu vermeiden, sollte die Zeitspanne zwischen 10 ms und 2 s, bevorzugt zwischen 30 ms und 1,3 s liegen. Besonders bevorzugt liegt die Zeitspanne zwischen 50 ms und 0,9 s. Die vorliegenden Zeitspannen sind so zu wählen, dass die Betätigung des virtuellen Schalters z. B. wie bei einem Fußtaster ablaufen soll. Dieser wird üblicherweise kurz durch den Fuß angetippt und direkt wieder losgelassen, wobei sich der Fuß zunächst dem Taster nähert und sich dann wieder entfernt. Nicht hingegen soll z. B. der virtuelle Schalter betätigt werden, falls sich jemand in den Detektionsbereich der Sensoren stellt, um z. B. das Fahrzeug zu reinigen oder frei zu kratzen. Auch das Durchrollen eines Balles oder das Durchlaufen einer Katze durch die Detektionsbereiche führt somit nicht zu einer Betätigung des Schalters. Zweckmäßigerweise messen die Sensoren ein Herantreten an das Fahrzeug, die Tippbewegung des Fußes auf den virtuellen Schalter und das anschließende Entfernen, wodurch der virtuelle Schalter ein Betätigungssignal auslöst, um das bewegliche Teil, insbesondere eine Tür oder Klappe oder dergleichen, bei dem Fahrzeug automatisch zu öffnen bzw. zu schließen.

Um jedoch grundsätzlich ein ungewolltes Öffnen des beweglichen Teils beim Fahrzeug zu vermeiden, selbst wenn das richtige Bewegungsmuster ausgeführt worden ist, kann vorgesehen sein, dass spätestens nach Schritt b) eine Authentisierungsabfrage mit einem mobilen ID-Geber gestartet wird, um ein Zugangsberechtigungs- oder Sicherheitssystem frei zu schalten. Auch kann es vorgesehen sein, dass zunächst eine Authentisierungsabfrage mit dem mobilen ID-Geber durchgeführt werden muss, bevor das Sensorsystem des virtuellen Schalters eingeschaltet wird. Diese Authentisierungsabfrage mit dem mobilen ID-Geber kann auch erst nach einem erfolgreichen Betätigen des virtuellen Schalters stattfinden, wenn die Zeit noch ausreicht, das bewegliche Teil zu öffnen oder zu schließen. Allerdings eignet sich der virtuelle Schalter ebenfalls dazu, eine Annäherung des Fahrers an ein Fahrzeug messtechnisch zu erfassen, um dann die Authentisierungsfrage mit dem mobilen ID-Geber sehr früh zu starten. Soll jedoch der virtuelle Schalter mit seinem Sensorsystem nicht zum Starten der Authentisierungsabfrage herangezogen werden, so ist ein zusätzlicher Näherungssensor erforderlich, um diesen Schritt zu übernehmen.

Um sicher Fehlfunktionen des virtuellen Schalters zu vermeiden, ist es denkbar, dass das erfindungsgemäße Verfahren erst dann beginnt, wenn das Fahrzeug eine Geschwindigkeit unter 3 km/h aufweist bzw. wenn das Fahrzeug sicher steht. Ebenfalls kann es vorgesehen sein, dass alle Sensoren des Sensorsystems zunächst deaktiviert sind, bevor das Verfahren erstmalig beginnt. Optional ist es möglich, dass das Verfahren dann nicht beginnt, wenn ein ID-Geber im Fahrzeuginneren festgestellt wird. Dabei ist es gleichgültig, ob das Fahrzeug steht und/oder ob das Zugangsberechtigungssystem, die Zentralverriegelung oder dergleichen ein- oder ausgeschaltet ist. Ferner lässt sich durch das temporäre Einschalten des erfindungsgemäßen Verfahrens auch elektrische Energie einsparen, was besonders wichtig ist, wenn das Fahrzeug bereits eine längere Zeit gestanden hat.

Des Weiteren kann bei dem erfindungsgemäßen Verfahren vorgesehen sein, dass ein vorgegebenes Bewegungsmuster zur Betätigung des virtuellen Schalters erforderlich ist, wobei das Bewegungsmuster durch die Reihenfolge der Deaktivierung der Sensoren gemäß der Schritte e) bzw. e') und die Zeitspannen für die Timer in dem Verfahren selbst hinterlegt sind. Somit ist es auf einfache Art und Weise möglich, ein konkretes Bewegungsmuster zur Betätigung des virtuellen Schalters individuell durch das erfindungsgemäße Verfahren zu realisieren. Hiermit lässt sich das Verfahren auch auf unterschiedliche Personen auf einfache Art und Weise anpassen, die auch individuell einen derartigen virtuellen Schalter betätigen. Trotzdem leidet hierunter nicht die Funktionssicherheit, da eben genau andere durchgeführte Bewegungsmuster von dem virtuellen Schalter als Fehlbedienung erkannt werden, wodurch es eben nicht zu einer Betätigung kommt.

Die örtliche Anordnung der Sensoren kann ebenfalls für das messtechnische Erfassen des Bewegungsmusters relevant sein, wobei im Rahmen der Erfindung nicht vorgegeben ist, ob z. B. der erste Sensor über oder neben dem zweiten Sensor angeordnet ist oder nicht.

Wie bereits erwähnt worden ist, ist die vorliegende Erfindung auch auf eine Vorrichtung zur Betätigung eines virtuellen Schalters gerichtet. Dabei umfasst der virtuelle Schalter ein Sensorsystem, welches eine Betätigung des virtuellen Schalters erfasst, wobei das Sensorsystem zumindest zwei berührungslose Sensoren aufweist. Ebenfalls umfasst der virtuelle Schalter eine Steuereinheit, die wenigstens einen ersten Timer und einen Speicher für eine erste Zeitspanne aufweist, wobei die Steuereinheit die Sensoren messtechnisch überwacht. Bei dieser Vorrichtung ist es vorgesehen, dass in der Steuereinheit das erfindungsgemäße Verfahren zum Betrieb der Vorrichtung gespeichert bzw. hinterlegt ist.

Bei den berührungslosen Sensoren, kann es sich um Kapazitätssensoren oder Ultraschallsensoren handeln. Ebenfalls können auch andere Annäherungssensoren zum Einsatz kommen. Vorteilhafterweise werden Kapazitätssensoren verwendet, da diese sicher und geschützt hinter einer Verkleidung angeordnet werden können und nicht im direkten Kontakt zur Umwelt des Fahrzeugs stehen müssen.

Merkmale und Details, die im Zusammenhang mit dem erfindungsgemäßen Verfahren beschrieben sind, gelten dabei selbstverständlich auch im Zusammenhang mit der erfindungsgemäßen Vorrichtung und umgekehrt.

Weitere, die Erfindung verbessernde Maßnahmen werden nachstehend gemeinsam mit der Beschreibung von bevorzugten Ausführungsbeispielen der Erfindung anhand der Figuren näher dargestellt. Es zeigen:

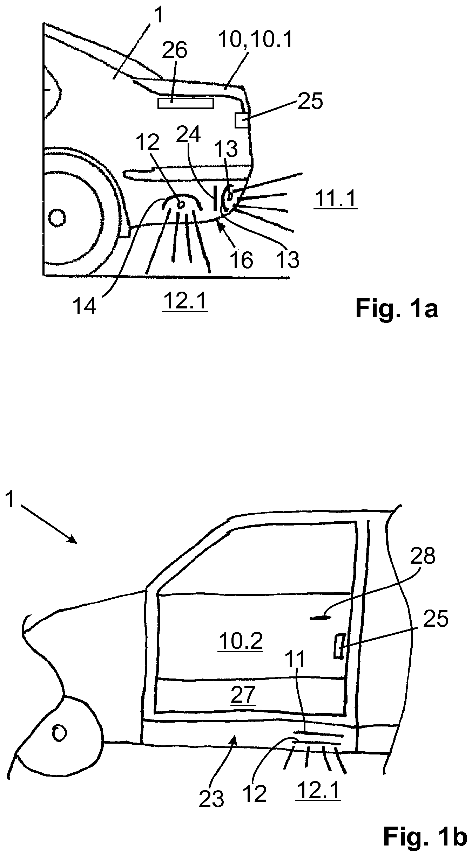

- Figur 1a: ein Ausführungsbeispiel der erfindungsgemäßen Vorrichtung zum berührungslosen Betätigen einer Heckklappe mit zwei Sensoren,
- Figur 1 b: ein weiteres Ausführungsbeispiel der Vorrichtung zum berührungslosen Betätigen einer Seitentür mit dem virtuellen Schalter,
- Figur 2: ein konkretes Ausführungsbeispiel zum Betätigen des virtuellen Schalters durch ein Bein und einen Fuß einer Person,
- Figur 3: eine schematische Draufsicht der Anordnung der Sensoren innerhalb eines hinteren Stoßfängers eines Fahrzeugs,
- Figur 4: eine schematische Seitenansicht der Anordnung des zweiten Sensors innerhalb des hinteren Stoßfängers eines Fahrzeugs mit einer metallischen Abschirmung,
- Figur 5: eine Schemaansicht des virtuellen Schalters, mit der Steuereinheit in Wirkverbindung mit dem Sensorsystem und den Sensoren, dem ID-Geber und der Heckklappe,
- Figur 6: schematisches Zeitdiagramm zur Betätigung des virtuellen Schalters bei einem ersten Bewegungsmuster,
- Figur 7: schematisches Zeitdiagramm zur Betätigung des virtuellen Schalters bei einem zweiten Bewegungsmuster,
- Figur 8: schematisches Zeitdiagramm zur Betätigung des virtuellen Schalters bei einem zweiten Bewegungsmuster, jedoch bei einer fehlgeschlagenen Betätigung des virtuellen Schalters,
- Figur 9: schematisches Zeitdiagramm zur Betätigung des virtuellen Schalters bei einem zweiten Bewegungsmuster, bei einer weiteren Fehlbetätigung des virtuellen Schalters,
- Figur 10: schematisches Flussdiagramm für ein Beispiel des erfindungsgemäßen Verfahrens,
- Figur 11: schematisches Flussdiagramm für ein weiteres Beispiel des erfindungsgemäßen Verfahrens, und
- Figur 12: schematisches Flussdiagramm für ein weiteres Beispiel des erfindungsgemäße Verfahren.

Figur 1 a zeigt ein Ausführungsbeispiel der erfindungsgemäßen Einrichtung zum berührungslosen Betätigen einer Heckklappe 10.1 als bewegliches Teil 10 eines Fahrzeugs 1, welches ein Kraftfahrzeug darstellt. Das bewegliche Teil 10 wird durch ein elektromechanisches Schloss 25 in der Schließstellung gehalten und gesichert. Der virtuelle Schalter 50 umfasst einen ersten Sensor 11 zur Detektion eines Objektes 17, 17.1 in einem ersten Detektionsbereich 11.1 und einen zweiten Sensor 12 zur Detektion eines Objektes 17, 17.2 in einem zweiten Detektionsbereich 12.1. Die Sensoren 11 und 12 sind als Kapazitätssensoren 11 und 12 ausgebildet und in der Ansicht lediglich schematisch angedeutet. Der Detektionsbereich 11.1 deckt den horizontalen Bereich hinter dem hinteren Stoßfänger 16 des Fahrzeugs 1 ab. Hingegen deckt der Detektionsbereich 12.1 den unteren Bereich unterhalb des hinteren Stoßfängers 16 ab. Damit ist ein erster Detektionsbereich 11.1 und ein zweiter Detektionsbereich 12.1 geschaffen, die beispielsweise geometrisch voneinander getrennt sind und keinen gemeinsamen Bereich außenseitig vom hinteren Stoßfänger 16 umfassen. Selbstverständlich können sich grundsätzlich die Detektionsbereiche 11.1, 12.1 auch teilweise überlappen. Die Detektionsbereiche 11.1 und 12.1 sind in den Figuren durch Strahlen angedeutet, die jedoch lediglich Bereiche andeuten, in denen eine Änderung der Dielektrizitätskonstante zwischen den Kapazitätssensoren 11 und 12 sowie der Umgebung des hinteren Stoßfängers 16 beschreiben. Diese Änderung der Dielektrizitätskonstante bewirkt eine Änderung der auf den Elektroden der Kapazitätssensoren 11 und 12 speicherbaren Ladung, die von der Einrichtung detektiert werden kann. Damit kann durch die Kapazitätssensoren 11 und 12 das Vorhandensein eines Objektes 17, insbesondere das Vorhandensein von Körperteilen einer Person bei minimalem Stromverbrauch bereitgestellt werden.

Hinter den Kapazitätssensoren 11 und 12 erstrecken sich Mittel 13 und 14, die in Gestalt metallischer Abschirmungen 13 und 14 ausgeführt sind und die die Kapazitätssensoren 11 und 12 bogenartig oder halbschalenartig umschließen. Durch die Abschirmungen 13 und 14 wird sowohl der jeweilige Detektionsbereich 11.1 und 12.1 vorgegeben, wobei eine verbesserte Trennung der Detektionsbereiche 11.1 und 12.1 voneinander ermöglicht wird. Die metallischen Abschirmungen 13 und 14 weisen das gleiche elektrische Potential auf wie die entsprechenden Kapazitätssensoren 11 und 12. Somit handelt es sich hierbei um sogenannte "Active Shields" 13, 14. Hinter diesen "Active Shields" 13, 14 können zusätzlich Masseelektroden 24 bzw. Masseabschirmungen 24 vorgesehen sein, womit die Detektionsbereiche 11.1, 12.1 der Kapazitätssensoren 11 und 12 in die umgekehrte Richtung zu den Masseabschirmungen 24 gerichtet werden, d. h. von den Masseabschirmungen 24 weg. Die Masseelektroden 24 sind in der Regel direkt über einen Massekontakt 19 mit der Fahrzeugmasse verbunden.

In der Figur 1b ist ein ähnliches Ausführungsbeispiel der erfindungsgemäßen Einrichtung zum berührungslosen Betätigen einer Seitentür bzw. Schiebetür 10.1 als bewegliches Teil 10 eines Fahrzeugs 1 dargestellt. Hierbei sind die beiden Kapazitätssensoren 11 und 12 im Türschwellerbereich 23 angeordnet und vergleichbar zur erwähnten Stoßstange 16 im Heckbereich 15 ausgerichtet. Optional können die beiden Kapazitätssensoren 11 und 12 auch im unteren Bereich 27 der Seitentür 10.2, vorzugsweise unter einem Steinschlagschutz, angeordnet sein. Eine Annäherung des Objektes 17 an die Seitentür 10.2 kann durch den ersten Kapazitätssensor 11 oder den Annäherungssensor für das Zugangsberechtigungssystem, der in der Regel im Türgriff 28 angeordnet ist, ermittelt werden. Bei der weiteren Erkennung eines Bewegungsmusters für die Betätigung des beweglichen Teils 10 durch die Erkennungsmittel 11, 12 unterscheiden sich die Ausführungsbeispiele aus den Figuren 1 bis 5 nicht. Auch können die Erkennungsmittel 11, 12 mit den dazu gehörenden Mittel 13, 14 optional mit einer Masseabschirmung 24 versehen sein.

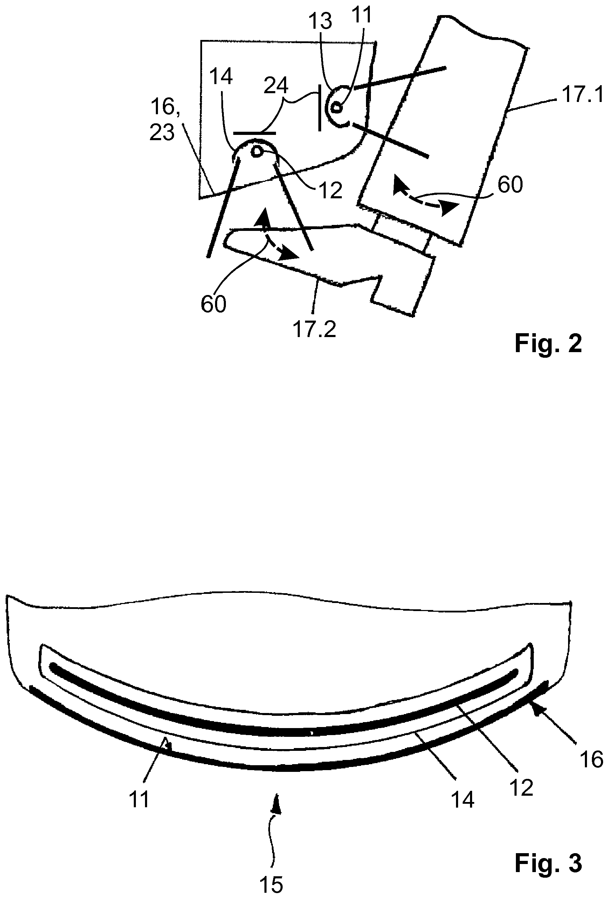

In Figur 2 ist in einer Seitenansicht ein Ausschnitt des hinteren Stoßfängers 16 bzw. des unteren Bereiches der Seitentür 10.2 gezeigt, in dem die Kapazitätssensoren 11 und 12 mit den jeweiligen Abschirmungen 13 und 14 eingebracht sind. Gemäß der Darstellung ist ein Bein 17.1 einer Person teilweise gezeigt und ragt in den horizontal verlaufenden ersten Detektionsbereich 11.1 hinein. Der sich an das Bein 17.1 anschließende Fuß 17.2 ragt hingegen in den sich vertikal unterhalb des hinteren Stoßfängers 16 bzw. des Türschwellerbereiches 23 erstreckenden Detektionsbereich 12.1 hinein. Die Person hat sich beispielhaft dem Fahrzeug 1 im Bereich des hinteren Stoßfängers 16 bzw. der Seitentür 10.2 genähert. Folglich kann der erste Kapazitätssensor 11 durch das Eindringen des Beines 17.1 in den ersten Detektionsbereich 11.1 die Annäherung der Person detektieren. Signalisiert die Person die Absicht der Betätigung des beweglichen Teils 10 durch ein Hin- und Herbewegen des Fußes 17.2 in den zweiten Detektionsbereich 12.1, so entsteht ein vorgegebenes Bewegungsmuster 60 der Person. Durch die gekoppelte Detektion sowohl des Beines 17.1 als auch des Fußes 17.2 kann die Betätigung der Heckklappe 10.1 bzw. der Seitentür 10.2 ausgelöst werden. Ebenfalls kann durch ein nicht dargestelltes Leucht- und/oder Anzeigemittel die entsprechenden Detektionsbereiche 11.1, 12.1 ausgeleuchtet werden. Auch kann der Zustand des beweglichen Teils 10 auf dem Bürgersteig oder der Strasse neben dem Fahrzeug durch eine Schrift angezeigt werden. Bei der Betätigung wird das elektromechanische Schloss 25 derart verstellt, dass es das bewegliche Teil 10 freigibt, wodurch es von einer Schließstellung in eine Offenstellung überführbar ist. Der Öffnungsund/oder Schließvorgang kann selbst mechanisch durch den in Figur 1 a angedeuteten Aufstellmechanismus 26 erfolgen, der ebenfalls durch die Betätigung des virtuellen Schalters aktiviert wird.

Figur 3 zeigt in einer Draufsicht die Anordnung der Sensoren 11 und 12 innerhalb des hinteren Stoßfängers 16 des Fahrzeugs 1. Der hintere Stoßfänger 16 erstreckt sich über den gesamten Heckbereich 15 des Fahrzeugs, wobei der Stoßfänger 16 in der gesamten Breite gezeigt ist. Gemäß der Darstellung ist erkennbar, dass sich die Sensoren 11 und 12 etwa über die gesamte Breite des Stoßfängers 16 hinweg erstrecken können. Folglich kann sich eine Person an einer beliebigen Stelle über dem gesamten Heckbereich 15 des Fahrzeugs 1 nähern und die in Figur 2 beschriebene Bewegung des Beines 17.1 sowie des Fußes 17.2 ausführen.

Die Darstellung zeigt die Anordnung des ersten Kapazitätssensors 11 im vertikalen Bereich des Stoßfängers 16, wohingegen der zweite Kapazitätssensor 12 mit der diesen umschließenden Abschirmung 14 im unteren Bereich des Stoßfängers 16 angedeutet ist. Die Kapazitätssensoren 12 können folienartig oder leiterbahnartig über der Breite des Stoßfängers 16 in diesem eingebracht oder verlegt sein. Vorzugsweise werden die Kapazitätssensoren 11 und 12 mit den jeweiligen Abschirmungen 13 und 14 innenseitig im Stoßfänger 16 angeordnet.

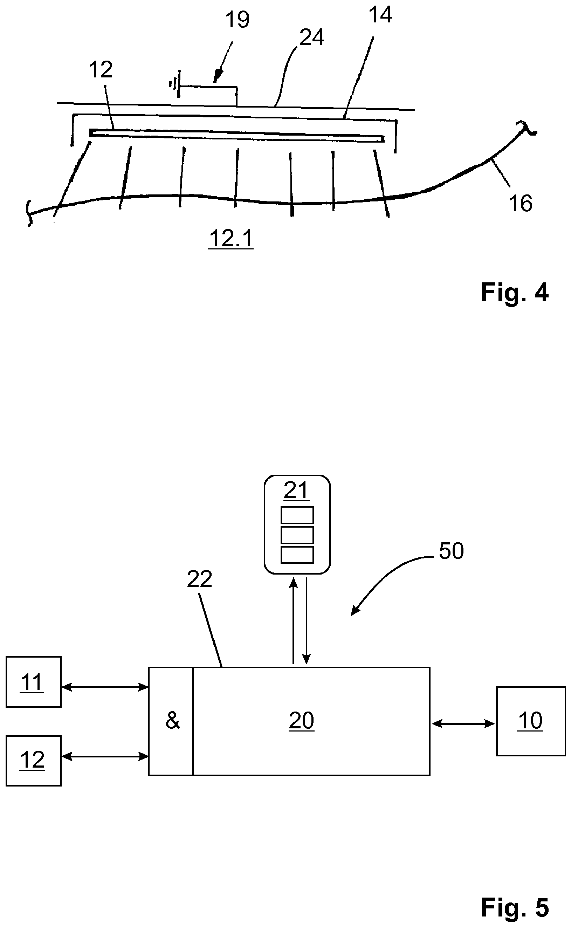

Figur 4 zeigt eine schematische Seitenansicht der Anordnung des zweiten Kapazitätssensors 12 innerhalb des Stoßfängers 16, der ebenso gut in oder an der Seitentür 10.2 oder dem dazu gehörenden Türschweller angeordnet sein könnte. Der Kapazitätssensor 12 ist im Querschnitt dargestellt und besitzt eine flächenförmige Erstreckung.

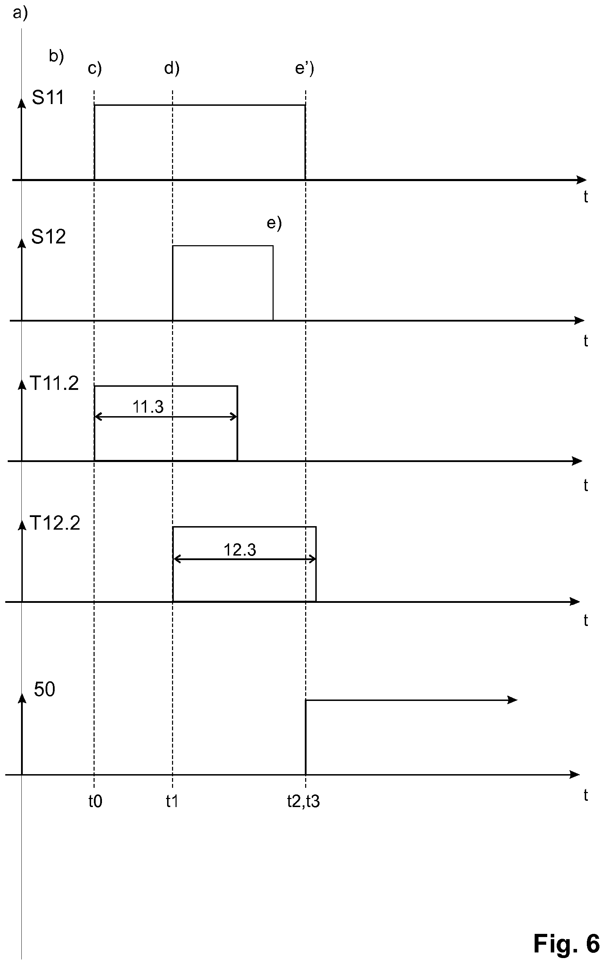

Figur 5 zeigt in einer schematischen Ansicht die Wirkverbindung der Steuereinheit 20 mit dem ersten Sensor 11 und dem zweiten Sensor 12. Die Steuereinheit 20 weist eine Logikeinheit 22 auf, die als UND-Verknüpfungsglied angedeutet ist. In den weiteren Figuren 6 bis 10 wird das erfindungsgemäße Verfahren näher dargestellt und erläutert.

In Figur 6 ist ein erstes zeitliches Ablaufdiagramm für das erfindungsgemäße Verfahren dargestellt. Bei diesem Verfahren werden nur die beiden Sensoren 11, 12 eingesetzt, die jeweils bei ihrer Aktivierung den Timer 11.2 bzw. 12.2 starten, sofern das entsprechende Bewegungsmuster korrekt durchgeführt wird. Wie zu erkennen ist, sind zunächst die beiden Sensoren 11 und 12 deaktiviert. Dann erfasst der Sensor 11 ein Objekt 17 zum Zeitpunkt t0, wodurch er aktiviert wird. Durch die Aktivierung des Sensors 11 wird der erste Timer 11.2 gestartet, der eine vordefinierte Zeitspanne 11.3 läuft. In dieser Zeitspanne 11.3 erfasst der zweite Sensor 12 das Objekt 17 zum Zeitpunkt t1, wodurch auch der zweite Timer 12.2 ebenfalls für eine vordefinierte Zeitspanne 12.3 gestartet wird. Je nach Variante des erfindungsgemäßen Verfahrens kann es zur Betätigung des virtuellen Schalters gemäß Schritt e) kommen, falls der zweite Sensor 12 innerhalb der Zeitspanne 12.3 des zweiten Timers 12.2 deaktiviert wird. Zur Verdeutlichung sind die einzelnen Verfahrensschritte a) bis e) bzw. e') in dem zeitlichen Ablaufdiagramm eingetragen. Im vorliegenden Fall aus Figur 6 muss jedoch zusätzlich auch der erste Sensor 11 deaktiviert werden (siehe Schritt e')) und zwar innerhalb der Zeitspanne 12.3 des zweiten Timers 12.2, damit der virtuelle Schalter 50 betätigt wird und ein Betätigungssignal für das bewegliche Teil 10 erzeugt.

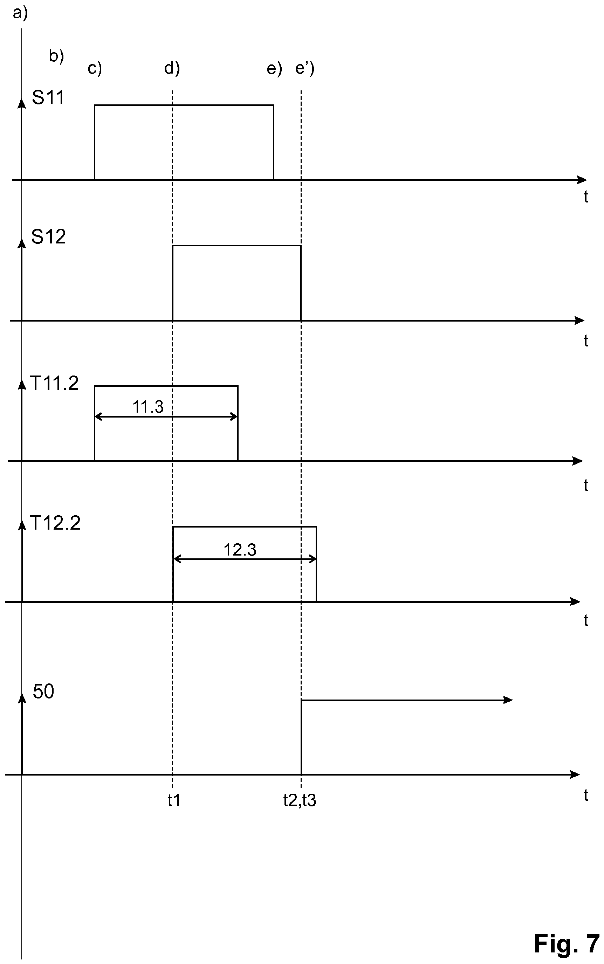

In der Figur 7 ist eine weitere Variante für den Ablauf des erfindungsgemäßen Verfahrens dargestellt. Im Gegensatz zur Variante aus Figur 6 wird hierbei erst der erste Sensor 11 deaktiviert und dann der zweite Sensor 12. Der virtuelle Schalter 50 wird zum Zeitpunkt t2 bzw. t3 betätigt, wenn der zweite Sensor 12 innerhalb der Zeitspanne 12.3 deaktiviert wird.

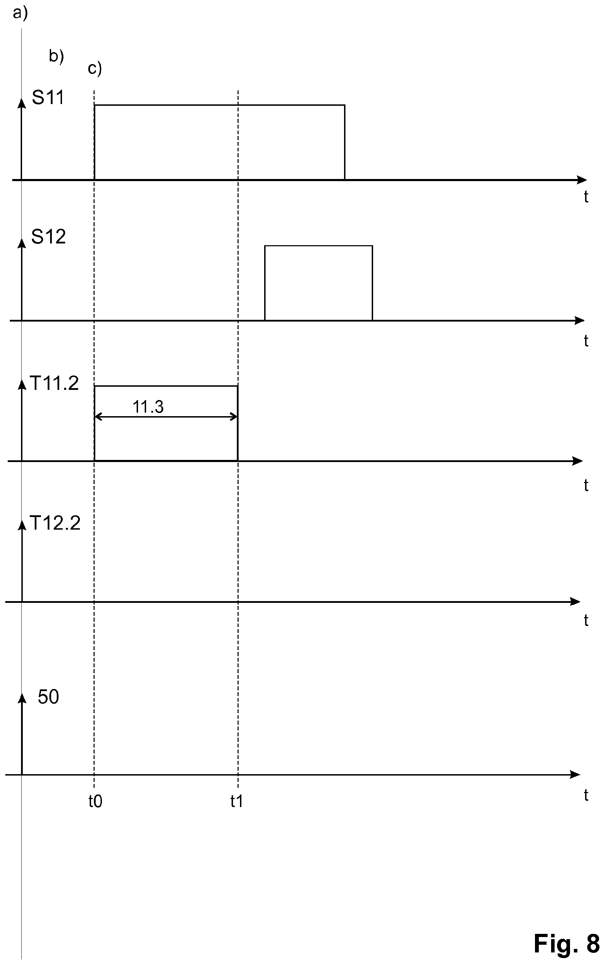

In der Figur 8 ist ein erster Fall eines falschen Bewegungsmusters zur Betätigung des virtuellen Schalters 50 dargestellt. Hierbei beginnt das erfindungsgemäße Verfahren ganz normal mit Schritt a), woraufhin im Schritt b) der erste Sensor 11 überwacht wird und zum Zeitpunkt t0 aktiviert wird. Hierdurch wird der erste der Timer 11.2 für seine vordefinierte Zeitspanne 11.3 gestartet (siehe Schritt c)). Allerdings wird innerhalb der Zeitspanne 11.3 weder der erste Sensor 11 deaktiviert noch wird der zweite Sensor 12 aktiviert. Somit läuft die Zeitspanne 11.3 für den Timer 11.2 ungenutzt ab, da keine weitere Bewegung in dieser Zeitspanne 11.3 von den Sensoren 11, 12 erkannt wird. Folglich wird auch nicht der Schritt d) und somit auch nicht Schritt e) eingeleitet. Das vorliegende Verfahren wird erst wieder gestartet, wenn die beiden Sensoren 11 und 12 deaktiviert sind (siehe Anspruch 2).

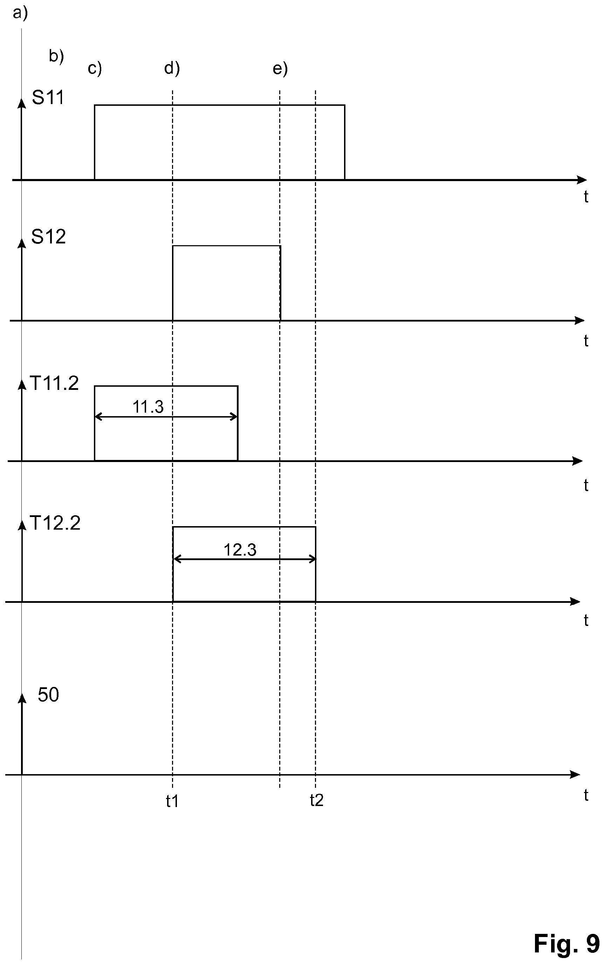

In der Figur 9 ist ein zweiter Fall eines falschen Bewegungsmusters zur Betätigung des virtuellen Schalters 50 dargestellt. Hierbei beginnt wieder das erfindungsgemäße Verfahren ganz normal mit Schritt a), woraufhin im Schritt b) der erste Sensor 11 überwacht wird und zum Zeitpunkt t0 aktiviert wird. Hierdurch wird der erste der Timer 11.2 für seine vordefinierte Zeitspanne 11.3 gestartet (siehe Schritt c)). In dieser Zeitspanne 11.3 wird dann der zweite Sensor 12 aktiviert und der Timer 12.3 gestartet, siehe Schritt c). Wie in Figur 6 wird anschließend der zweite Sensor 12 noch deaktiviert und zwar innerhalb der Zeitspanne 12.3. Allerdings wird zusätzlich nicht der erste Sensor 11 in der Zeitspanne 12.3 deaktiviert, sondern erst später (siehe nur Schritt e)). Damit liefert der virtuelle Schalter 50 kein Betätigungssignal, da die Voraussetzungen für Schritt e') nicht erfüllt sind. Das vorliegende Verfahren wird erst wieder gestartet, wenn die beiden Sensoren 11 und 12 deaktiviert sind (siehe Anspruch 2).

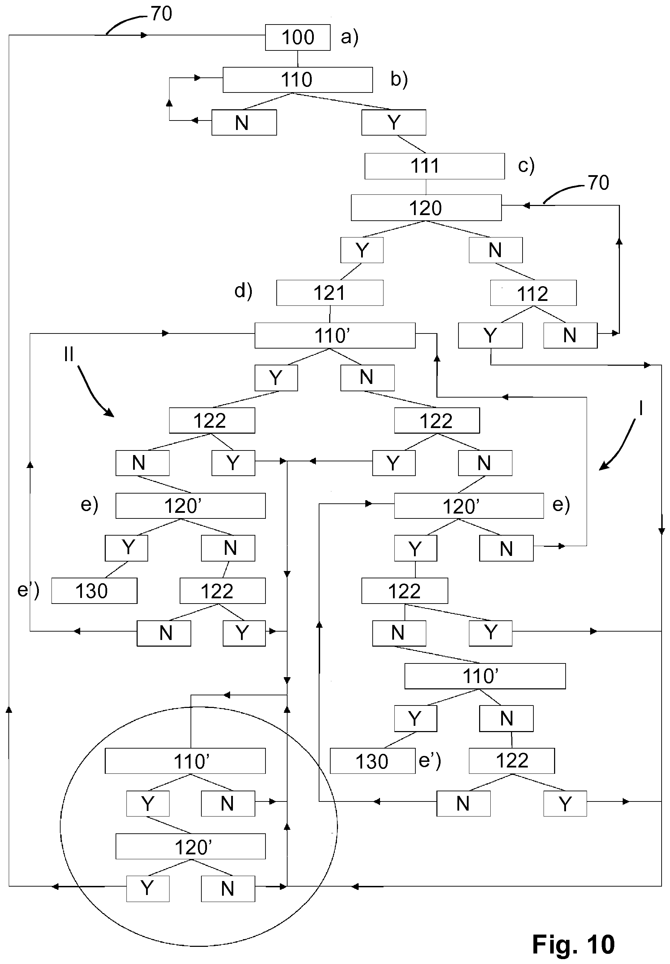

In der Figur 10 ist das Flussdiagramm für das erfindungsgemäße Verfahren dargestellt, in dem beide Varianten zur Erkennung des konkreten Bewegungsmusters zur Betätigung des virtuellen Schalters 50 gemäß Schritt e') vorhanden sind. Bei der ersten Variante I muss zunächst der zweite Sensor 12 deaktiviert werden. Diese Deaktivierung muss innerhalb der Zeitspanne 12.3 des zweiten Timers 12.2 stattfinden (siehe auch Figur 6). Hier wird der rechte Pfad I des Flussdiagramms mit Schritt e) gezeigt. Bei der zweiten Variante II im linken Pfad II des Flussdiagramms aus Figur 10 muss zunächst der erste Sensor 11 deaktiviert werden (siehe Schritt e)) und dann der zweite Sensor 12 (siehe Schritt e')). Das Deaktivieren des zweiten Sensors 12 muss innerhalb der Zeitspanne 12.3 des zweiten Timers 12.2 stattfinden, um den virtuellen Schalter 50 zu betätigen. Dieser linke Pfad II im Schritt e) im Flussdiagramm 10 entspricht dem Verfahrensablauf in der Figur 7.

Wie der Figur 10 deutlich zu entnehmen ist, ist in dem vorliegenden Fall das Verfahren abgeschlossen, wenn der zweite Timer 12.2 abgelaufen ist und noch ein Sensor 11 bzw. 12 aktiviert ist. In diesem Fall wird dann unumgänglich überprüft, ob zunächst der Sensor 11 deaktiviert ist und dann, ob der Sensor 12 deaktiviert ist. Erst wenn die beiden Sensoren 11 und 12 deaktiviert sind, wird das Verfahren bei Schritt a) (siehe Bezugszeichen 100) neu gestartet. In dem Bezugszeichen 110 wird der Sensor 11 zur Aktivierung abgefragt. Bei dem Bezugszeichen 111 wird der erste Timer 11.2 gestartet. Bei dem Bezugszeichen 110' wird der Sensor 11 auf eine Deaktivierung abgefragt. Bezugszeichen 112 steht für eine Abfrage des ersten Timers 11.2, ob die Zeitspanne 11.3 bereits abgelaufen ist. Die Abfrage, ob der zweite Sensor 12 aktiviert ist, wird durch das Bezugszeichen 120 angedeutet. Die Deaktivierung des zweiten Sensors 12 wird beim Bezugszeichen 120' abgefragt. Der zweite Timer 12.2 wird beim Bezugszeichen 121 gestartet. Der Zeitablauf des zweiten Timers 12.2 wird im Bezugszeichen 122 abgefragt. Im Bezugszeichen 130 findet die Betätigung des virtuellen Schalters 50 statt.

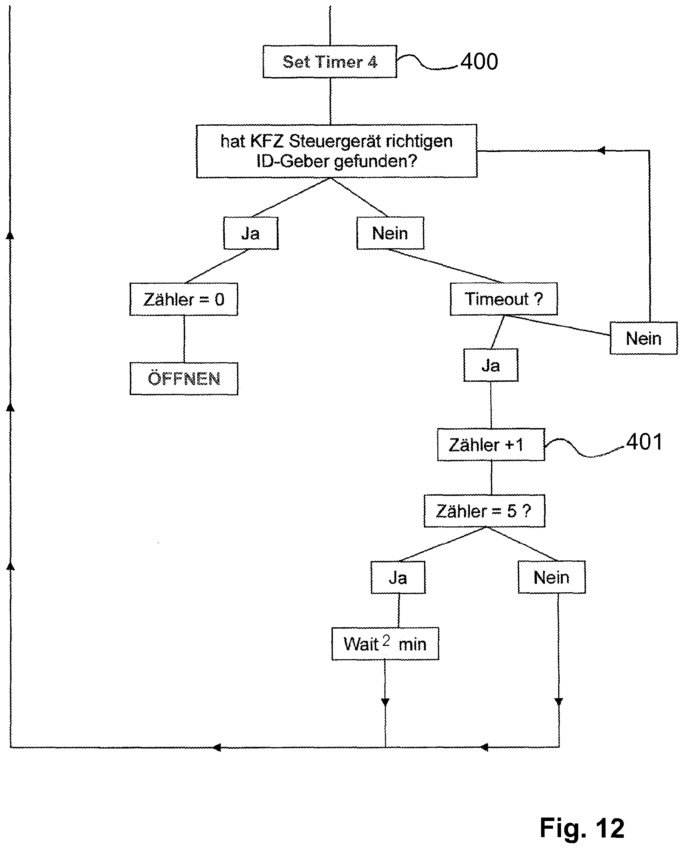

In der weiteren Figur 12 ist eine bevorzugte Ausführungsform der Erfindung beschrieben, in welcher die Funktionsweise des Timers 400 im Folgenden offenbart wird. Bevor die Heckklappe sich öffnen soll, findet zuvor eine Abfrage statt, welche durch einen Timer 400 durchgeführt wird. Der Timer 400 prüft, ob das Kfz-Steuergerät den richtigen ID-Geber gefunden hat. Falls das Kfz-Steuergerät den richtigen ID-Geber nicht gefunden hat, wird über einen vorbestimmten Zeitraum (beispielsweise 5 Sekunden) lang überprüft, ob sich tatsächlich kein ID-Geber in der Umgebung der zu öffnenden Klappe befindet. Falls nach dem Ablauf des vorbestimmten Zeitraums kein ID-Geber gefunden wurde, wird ein Zählerspeicher 401 auf den Wert 1 gesetzt. Der gesetzte Wert wird mit einem vorbestimmten festen Wert verglichen - in dem vorliegenden Ausführungsbeispiel ist der Wert auf 5 gesetzt, wobei 5 die Höchstanzahl der Schleifen ist - und wenn der gesetzte Wert kleiner als der vorbestimmte Wert ist, dann wird das Verfahren bei Schritt a) (siehe Bezugszeichen 100) neu gestartet. Wenn der gesetzt Wert = dem vorbestimmten Wert ist, dann wird das Verfahren für einen vorbestimmten Zeitraum gestoppt (im vorliegenden Ausführungsbeispiel 2 Minuten). Nach Ablauf des vorbestimmten Zeitraums wird das Verfahren bei Schritt a) (siehe Bezugszeichen 100) neu gestartet.

Hat das Kfz-Steuergerät den richtigen ID-Geber gefunden, dann wird der Zählerspeicher auf Null gesetzt und die Betätigung des virtuellen Schalters 50 findet statt.

Der Timer 400 verringert in vorteilhafter Weise eine ungewollte, wiederkehrende und umweltbedingte Fehlauslösung.

Anstelle eines Zählers kann auch die Empfindlichkeit des Feldes, der Detektionsbereich oder der Detektionsschwellwert verändert werden.

Das erfindungsgemäße Verfahren wird erst wieder gemäß Schritt a) gestartet, wenn eine Deaktivierung der beiden Sensoren 11, 12 stattgefunden hat (s. Kreis unten links in Fig. 10).

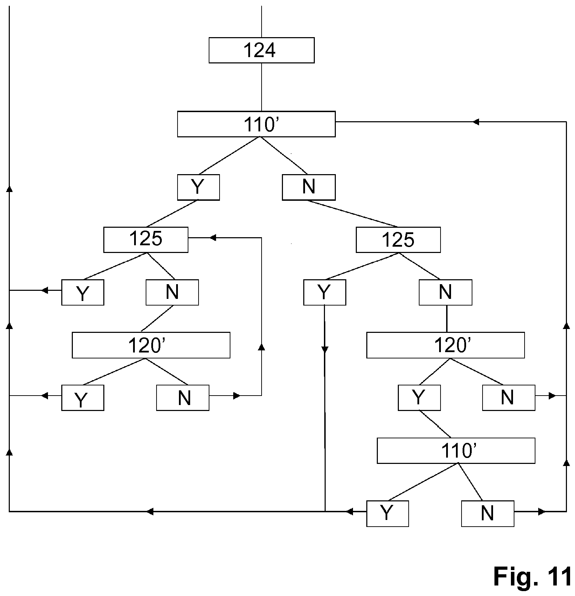

In der weiteren Figur 11 ist das erfindungsgemäße Verfahren aus dem Kreis unten links aus Figur 10 dargestellt gemäß dem Anspruch 2. Hierbei wird ein zusätzlicher Timer für eine vordefinierte Zeitspanne 124 gestartet. Anschließend wird der erste Sensor 110' auf Deaktivierung abgefragt. Bei einem Ja Y und auch bei einem Nein N wird jeweils weiter abgefragt, ob der zusätzlicher Timer abgelaufen ist 125. Sofern der zusätzliche Timer abgelaufen ist, startet das Verfahren bei Schritt a) erneut. Wie den beiden Verzweigungen link und rechts unter der Timerabfrage 125 zu entnehmen ist, wird links nur nach der Deaktivierung des zweiten Sensors 120' gefragt, bei der rechten Verzweigung wird zusätzlich nach dieser Frage auch noch einmal nach der Deaktivierung des ersten Sensors 110' gefragt, da zuvor die Frage für diese rechte Verzweigung verneint worden ist. Anschließend startet das Verfahren bei Schritt a) erneut.

Abschließend sei erwähnt, dass auch weitere Varianten des erfindungsgemäßen Verfahrens und der Vorrichtung denkbar sind. So kann z. B. die Dauer der Zeitspannen 11.3 und 12.3 unterschiedlich lang ausgestaltet sein. Auch kann wenigstens ein weiterer Sensor vorgesehen sein, dessen Aktivierung bzw. Deaktivierung ebenfalls überwacht wird, der optional einen weiteren Timer startet. Auch kann die zeitliche Abfragereihenfolge der dargestellten Sensoren 11, 12 und ihre örtliche Lage variieren.

## Patentansprüche

1. Verfahren zum Betätigen eines virtuellen Schalters (50) mit einem Sensorsystem (17.2), welches eine Betätigung des Schalters (50) erfasst, wobei das Sensorsystem (17.2) zumindest zwei berührungslose Sensoren (11, 12) aufweist,
wobei die folgenden Schritte ablaufen:
a) Starten des Verfahrens
b) Überwachen von wenigstens einem ersten Sensor (11)
c) Starten eines ersten Timers (11.2) für eine erste Zeitspanne (11.3), falls der erste Sensor (11) aktiviert wird
d) Starten eines zweiten Timers (12.2) für eine zweite Zeitspanne (12.3), falls der zweite Sensor (12) aktiviert wird und die erste Zeitspanne (11.3) noch nicht überschritten ist
e') Betätigen des virtuellen Schalters (50), falls zumindest zwei Sensoren (11, 12) deaktiviert sind und die zweite Zeitspanne (12.3) noch nicht überschritten ist
und wobei insbesondere die Schritte a) bis e') teilweise gleichzeitig oder zeitlich nacheinander ablaufen.

2. Verfahren nach Anspruch 1,
**dadurch gekennzeichnet,**
**dass** das Verfahren erst wieder gestartet wird, wenn alle Sensoren (11, 12) zunächst deaktiviert sind, wobei insbesondere der erste Sensor (11) und/oder dann der zweite Sensor (12) deaktiviert wird bzw. umgekehrt.

3. Verfahren nach Anspruch 1 oder 2,
**dadurch gekennzeichnet,**
**dass** nach Schritt d) zunächst der erste Sensor (11) bzw. zweite Sensor (12) deaktiviert wird.

4. Verfahren nach einem der vorhergehenden Ansprüche,
**dadurch gekennzeichnet,**
**dass** die erste Zeitspanne (11.3) und /oder die zweite Zeitspanne (12.3) fest vorgegeben ist, wobei insbesondere die Zeitspanne (11.3, 12.3) zwischen 10 ms und 2 s, bevorzugt zwischen 30 ms und 1,3 s bzw. zwischen 50 ms und 0,9 s liegt.

5. Verfahren nach einem der vorhergehenden Ansprüche,
**dadurch gekennzeichnet,**
**dass** bei einer erfolgreichen Betätigung des virtuellen Schalters (50) ein bewegliches Teil (10), insbesondere Tür(10.2), Klappe (10.1) oder dergleichen, bei einem Fahrzeug (1) geöffnet wird.

6. Verfahren nach einem der vorhergehenden Ansprüche,
**dadurch gekennzeichnet,**
**dass** spätestens nach Schritt b) eine Authentisierungsabfrage mit einem mobilen ID-Geber (21) gestartet wird, um ein Zugangs- oder Sicherheitssystem, insbesondere bei einem Fahrzeug (1), freizuschalten.

7. Verfahren nach einem der vorhergehenden Ansprüche,
**dadurch gekennzeichnet,**
**dass** vor dem ersten Starten des Verfahrens zunächst ein Kalibrierverfahren abläuft, um das Sensorsystem (17.2) mit den Sensoren (11, 12) zu kalibrieren.

8. Verfahren nach einem der vorhergehenden Ansprüche,
**dadurch gekennzeichnet,**
**dass** ein vorgegebenes Bewegungsmuster (60) zur Betätigung des virtuellen Schalters (50) erforderlich ist, wobei das Bewegungsmuster (60) durch die Reihenfolge der Deaktivierung der Sensoren (11, 12) nach Schritt e) bzw. e') und die Zeitspannen (11.3, 12.3) für die Timer (11.2, 12.2) in dem Verfahren hinterlegt wird.

9. Verfahren nach einem der vorhergehenden Ansprüche,
**dadurch gekennzeichnet,**
**dass** das Verfahren erst beginnt, wenn das Fahrzeug (1) eine Geschwindigkeit von unter 3 km/h aufweist und/oder alle Sensoren (11, 12) zunächst deaktiviert sind.

10. Vorrichtung zur Betätigen eines virtuellen Schalters (50) mit
einem Sensorsystem,
welches eine Betätigung des virtuellen Schalters (50) erfasst, wobei das Sensorsystem (17.2) zumindest zwei berührungslose Sensoren (11, 12) aufweist, und eine Steuereinheit (20), die wenigstens einen ersten Timer (11.2) und einen Speicher für eine erste Zeitspanne (11.3) aufweist, und die Steuereinheit (20) die Sensoren (11, 12) messtechnisch überwacht,
**dadurch gekennzeichnet,**
**dass** in der Steuereinheit (20) ein Verfahren gemäß der vorhergehenden Ansprüche zum Betrieb der Vorrichtung gespeichert ist.

## Claims

1. A method for actuating a virtual switch (50) by means of a sensor system (17.2) which detects an actuation of the switch (50), the sensor system (17.2) having at least two non-contact sensors (11, 12), wherein the method proceeds by the following steps:
a) starting the method
b) monitoring at least one first sensor (11)
c) starting a first timer (11.2) for a first time interval (11.3) if the first sensor (11) is activated
d) starting a second timer (12.2) for a second time interval (12.3) if the second sensor (12) is activated and the first time interval (11.3) is not yet exceeded, and
e') actuating the virtual switch (50) if at least two sensors (11, 12) are deactivated and the second time interval (12.3) is not yet exceeded,
and wherein in particular the steps a) to e') proceed partly simultaneously or sequentially.

2. The method according to claim 1,
**characterized in that**
the method is only restarted when all sensors (11, 12) are first deactivated, wherein in particular the first sensor (11) and/or then the second sensor (12) is deactivated or vice versa.

3. The method according to claim 1 or 2,
**characterized in that**
after step d) either the first sensor (11) or second sensor (12) is first deactivated.

4. The method according to any of the preceding claims,
**characterized in that**
the first time interval (11.3) and/or the second time interval (12.3) is fixedly specified, wherein in particular the time interval (11.3, 12.3) is between 10 ms and 2 s, preferably between 30 ms and 1.3 s, or between 50 ms and 0.9 s.

5. The method according to any of the preceding claims,
**characterized in that**
in the event of a successful actuation of the virtual switch (50), a moveable part (10), in particular door (10.2), flap (10.1), or similar of a vehicle (1) is opened.

6. The method according to any of the preceding claims,
**characterized in that**
no later than after step b) an authentication request is started by means of a mobile ID transmitter (21), in order to unlock an access or security system, in particular of a vehicle (1).

7. The method according to any of the preceding claims,
**characterized in that**
before the first time the method is started a calibration process first takes place, in order to calibrate the sensor system (17.2) by means of the sensors (11, 12).

8. The method according to any of the preceding claims,
**characterized in that**
a predefined movement pattern (60) for actuating the virtual switch (50) is required, wherein said movement pattern (60) is stored in the method through the sequence of the deactivation of the sensors (11, 12) after step e) or e') and the time intervals (11.3, 12.3) for the timers (11.2, 12.2).

9. The method according to any of the preceding claims,
**characterized in that**
the method only begins when the vehicle (1) has a speed of less than 3 km/h and/or when all sensors (11, 12) are first deactivated.

10. A device for actuating a virtual switch (50) having a sensor system,
which detects an actuation of the virtual switch (50), the sensor system (17.2) comprising at least two non-contact sensors (11, 12), and a control unit (20), which comprises a first timer (11.2) and a memory for a first time interval (11.3), and wherein the control unit (20) monitors the sensors (11, 12) using measurement technology,
**characterized in that**
a method according to the preceding claims for operating the device is stored in the control unit (20).

## Revendications

1. Procédé pour actionner un commutateur virtuel (50) comprenant un système de détection (17.2) qui détecte un actionnement du commutateur (50), le système de détection (17.2) comportant au moins deux détecteurs sans contact (11, 12), les étapes suivantes étant exécutées :
a) démarrage du procédé,
b) surveillance d'au moins un premier détecteur (11),
c) démarrage d'un premier chronomètre (11.2) pour un premier intervalle de temps (11.3) si le premier détecteur (11) est activé,
d) démarrage d'un deuxième chronomètre (12.2) pour un deuxième intervalle de temps (12.3) si le deuxième détecteur (12) est activé et le premier intervalle de temps (11.3) n'est pas encore dépassé,
e') actionnement du commutateur virtuel (50) si au moins deux détecteurs (11, 12) sont désactivés et le deuxième intervalle de temps (12.3) n'est pas encore dépassé,
les étapes a) à e') étant en particulier exécutées en partie simultanément ou consécutivement.

2. Procédé selon la revendication 1,
**caractérisé en ce**
**que** le procédé est redémarré seulement si tous les détecteurs (11, 12) sont d'abord désactivés, en particulier le premier détecteur (11) et/ou ensuite le deuxième détecteur (12) étant désactivés ou inversement.

3. Procédé selon la revendication 1 ou 2,
**caractérisé en ce**
**qu'**après l'étape d), d'abord le premier détecteur (11) ou le deuxième détecteur (12) est désactivé.

4. Procédé selon l'une des revendications précédentes,
**caractérisé en ce**
**que** le premier intervalle de temps (11.3) et/ou le deuxième intervalle de temps (12.3) sont définis de manière fixe, l'intervalle de temps (11.3, 12.3) étant en particulier compris entre 10 ms et 2 s, de préférence entre 30 ms et 1,3 s ou entre 50 ms et 0,9 s.

5. Procédé selon l'une des revendications précédentes,
**caractérisé en ce**
**qu'**en cas d'actionnement réussi du commutateur virtuel (50), une partie mobile (10), en particulier une porte (10.2), un couvercle (10.1) ou analogue d'un véhicule (1) est ouverte.

6. Procédé selon l'une des revendications précédentes,
**caractérisé en ce**
**qu'**au plus tard après l'étape b), une demande d'authentification est démarrée avec un émetteur d'identification mobile (21) pour déverrouiller un système d'accès ou de sécurité, en particulier sur un véhicule (1).

7. Procédé selon l'une des revendications précédentes,
**caractérisé en ce**
**qu'**avant le premier démarrage du procédé, un procédé de calibrage est d'abord exécuté pour calibrer le système de détection (17.2) avec les détecteurs (11, 12).

8. Procédé selon l'une des revendications précédentes,
**caractérisé en ce**
**qu'**un modèle de mouvements (60) prédéfini pour l'actionnement du commutateur virtuel (50) est nécessaire, le modèle de mouvements (60) étant enregistré dans le procédé par l'ordre de désactivation des détecteurs (11, 12) après l'étape e) ou e') et les intervalles de temps (11.3, 12.3) pour les chronomètres (11.2, 12.2).

9. Procédé selon l'une des revendications précédentes,
**caractérisé en ce**
**que** le procédé ne commence que si le véhicule (1) présente une vitesse inférieure à 3 km/h et/ou que tous les détecteurs (11, 12) sont d'abord désactivés.

10. Dispositif pour actionner un commutateur virtuel (50) comprenant un système de détection
qui détecte un actionnement du commutateur virtuel (50), le système de détection (17.2) comportant au moins deux détecteurs sans contact (11, 12), et une unité de commande (20) qui comporte au moins un premier chronomètre (11.2) et une mémoire pour un premier intervalle de temps (11.3), et l'unité de commande (20) surveillant les détecteurs (11, 12) au moyen de mesures,
**caractérisé en ce**
**qu'**un procédé selon l'une des revendications précédentes est enregistré dans l'unité de commande (20) pour faire fonctionner le dispositif.
